# EUROPEAN PATENT APPLICATION

(11) **EP 4 509 925 A1**
(43) Date of publication of application: **19.02.2025**
(21) Application number: 22936723.0
(22) Date of filing: 19.10.2022
(51) Int. Cl.: G03F 7/20

(54) **LITHOGRAPHY APPARATUS AND LITHOGRAPHY SYSTEM**

(30) Priority: 11.04.2022 CN 202210373960
(71) Applicant: Westlake University, Hangzhou, Zhejiang 310024 (CN)
(72) Inventor: LI, Xijun, Hangzhou, Zhejiang 310024 (CN)
(74) Representative: Held, Stephan
(86) International application number: PCT/CN2022/126126
(87) International publication number: WO 2023/197551

(57) **Abstract**

A lithographing apparatus and a lithographing system. The lithographing apparatus comprises: a signal generation module (110) configured to generate one or more mask patterns according to a layout, and to generate a respective mask driving signal according to each of the one or more mask patterns respectively; and a mask driving module (120) communicatively connected with the signal generation module (110) and configured to control a light-transmitting state of each pixel region on a mask (200) according to one or more sets of mask driving signals respectively, to form a respective mask pattern on the mask (200).

## Description

### CROSS-REFERENCE TO RELATED APPLICATIONS

The present application claims the priority to the Chinese Patent Application No. 202210373960.7 entitled "LITHOGRAPHING APPARATUS AND LITHOGRAPHING SYSTEM" filed on April 11, 2022, the disclosure of which is incorporated by reference herein in its entirety.

### TECHNICAL FIELD

The present disclosure generally relates to the technical field of lithography, and more particularly, to a lithographing apparatus and a lithographing system.

### BACKGROUND

From the early 1960s to the present, the technology of semiconductor chip (integrated circuit) production has been developed along a path of scaling down of transistors, and the lithography technology using a mask has always been the core technology in chip production. In the lithography technology, a patterned structure is formed by illuminating a mask with a uniform exposure beam. However, in the current lithography technology, once the mask is prepared, the pattern therein is not easy to be altered. Moreover, if a defect is present in the mask or generated in the process of usage of the mask, it is difficult to repair the defect. In addition, the mask typically has a high cost. These above factors all lead to an increase in the lithographing cost. Therefore, there is a need for the new lithography technology.

### SUMMARY

The objective of the present disclosure is to provide a lithographing apparatus and a lithographing system.

According to a first aspect of the present disclosure, there is provided a lithographing apparatus, comprising: a signal generation module configured to generate one or more mask patterns according to a design layout such as a chip design layout, and to generate a respective mask driving signal according to each of the one or more mask patterns respectively; and a mask driving module communicatively connected with the signal generation module and configured to control a light-transmitting state of each pixel region on a mask according to one or more sets of mask driving signals respectively, so as to form a respective mask pattern on the mask.

In some embodiments, the mask driving signal is configured to control an electrolytic reaction in the pixel region to change the light-transmitting state of the pixel region, and the mask driving signal comprises a first driving signal and a second driving signal configured to be respectively applied to a first control electrode and a second control electrode located on two sides of the pixel region.

In some embodiments, the mask driving signal is configured to drive a spatial optical modulator to generate a modulation beam, wherein the modulation beam has a spatial structure corresponding to the mask pattern and is configured to illuminate a photochromic material in the mask to generate the mask pattern in the mask.

In some embodiments, the lithographing apparatus further comprises: a first optical generator configured to generate an initial beam in a second frequency band, the initial beam having a uniform optical intensity distribution on a section perpendicular to its travelling direction; and the spatial optical modulator configured to convert the initial beam into the modulation beam with the spatial structure under an action of the mask driving signal.

In some embodiments, the mask driving signal comprises an erasing signal configured to erase the mask pattern on the mask.

In some embodiments, the mask driving module is configured to erase the mask pattern on the mask.

In some embodiments, the lithographing apparatus further comprises: a workpiece stage configured to hold a workpiece to be lithographed.

In some embodiments, the signal generation module is further configured to generate one or more workpiece positioning driving signals respectively corresponding to each of the one or more sets of mask driving signals, the workpiece positioning driving signal being configured to position the workpiece to be lithographed to a preset position.

In some embodiments, the lithographing apparatus further comprises: a workpiece stage driving module communicatively connected with the signal generation module and the workpiece stage, and configured to drive the workpiece stage to move to the corresponding preset position according to the one or more workpiece positioning driving signals respectively.

In some embodiments, the lithographing apparatus further comprises: a second optical generator configured to generate an exposure beam in a first frequency band.

In some embodiments, the lithographing apparatus further comprises: a projection module configured to project the mask pattern to a workpiece to be lithographed for imaging according to a preset multiple.

In some embodiments, the lithographing apparatus further comprises: a temperature controller comprising a temperature maintaining unit configured to be provided adjacent to the mask, to maintain a temperature of the mask within a preset temperature range.

According to a second aspect of the present disclosure, there is provided a lithographing system, comprising: the lithographing apparatus as described above; and a mask comprised in or provided independent of the lithographing apparatus, the mask comprising a plurality of pixel regions, wherein light-transmitting states for an exposure beam of at least a part of the plurality of pixel regions are configured to be changeable to form a changeable mask pattern.

In some embodiments, the mask comprises: an electrolytic reaction layer; a first control circuit layer provided on a first side of the electrolytic reaction layer and comprising a plurality of first control electrodes; and a second control circuit layer provided on a second side of the electrolytic reaction layer that is opposite to the first side and comprising a plurality of second control electrodes, wherein the light-transmitting state for the exposure beam of the pixel region in the mask is configured to be decided by a control voltage between at least a part of the first control electrode and at least a part of the second control electrode contained in the pixel region.

In some embodiments, the electrolytic reaction layer comprises metal element configured to be in a deposited-metal state or a dissolved-ion state, the control voltage controlling the light-transmitting state of the pixel region by controlling a deposition amount of metal in the electrolytic reaction layer.

In some embodiments, the electrolytic reaction layer comprises: an electrolyte layer; a first electrolytic material layer provided between the first control circuit layer and the electrolyte layer; and a second electrolytic material layer provided between the electrolyte layer and the second control circuit layer.

In some embodiments, the electrolyte layer comprises cuprum-plumbum electrolyte.

In some embodiments, the electrolyte layer comprises plumbum perchlorate, cupric chloride, cuprum perchlorate, and lithium perchlorate.

In some embodiments, the electrolyte layer comprises cuprum-argentum electrolyte.

In some embodiments, the electrolyte layer comprises cuprum perchlorate, silver perchlorate, and lithium chloride.

In some embodiments, one of the first electrolytic material layer and the second electrolytic material layer comprises conductive diamond, indium tin oxide, or indium tin oxide modified by platinum nanoparticles.

In some embodiments, another of the first electrolytic material layer and the second electrolytic material layer comprises platinum.

In some embodiments, the electrolytic reaction layer comprises an electrochromic material, the control voltage controlling the light-transmitting state of the pixel region by controlling an ion-bonding state of the electrochromic material in the electrolytic reaction layer.

In some embodiments, the electrolytic reaction layer comprises: an electrolyte layer; a first electrolytic material layer provided between the first control circuit layer and the electrolyte layer; and a second electrolytic material layer provided between the electrolyte layer and the second control circuit layer.

In some embodiments, at least one of lithium ions or hydrogen ions are dissolvable in the electrolyte layer.

In some embodiments, one of the first electrolytic material layer and the second electrolytic material layer comprises the electrochromic material.

In some embodiments, one of the first electrolytic material layer and the second electrolytic material layer comprises magnesium nickel alloy, magnesium yttrium alloy, niobium oxide, or niobium oxide modified by indium tin oxide nanoparticles.

In some embodiments, another of the first electrolytic material layer and the second electrolytic material layer comprises transition metal oxide.

In some embodiments, another of the first electrolytic material layer and the second electrolytic material layer comprises wolfram oxide.

In some embodiments, the electrolyte layer comprises solid electrolyte; or the electrolyte layer comprises liquid electrolyte.

In some embodiments, the electrolyte layer comprises an electrolyte material in a shape of continuous film; the first electrolytic material layer comprises a first electrolytic material in a shape of continuous film; and/or the second electrolytic material layer comprises a second electrolytic material in a shape of continuous film.

In some embodiments, the electrolyte layer comprises a plurality of electrolyte material blocks arranged in an array, and each pixel region in the mask comprises one or more electrolyte material blocks; the first electrolytic material layer comprises a plurality of first electrolytic material blocks arranged in an array, and each pixel region in the mask comprises one or more first electrolytic material blocks; and/or the second electrolytic material layer comprises a plurality of second electrolytic material blocks arranged in an array, and each pixel region in the mask comprises one or more second electrolytic material blocks.

In some embodiments, each of the plurality of first control electrodes is respectively connected to a first pole of a control power supply via a respective first switching device; and each of the plurality of second control electrodes is respectively connected to a second pole of the control power supply via a respective second switching device.

In some embodiments, each first control electrode is respectively configured to receive a first driving signal, and each second control electrode is respectively configured to receive a second driving signal, to control the light-transmitting state of the pixel region containing at least a part of the first control electrode and at least a part of the second control electrode that are overlapped.

In some embodiments, the first control electrode is a first strip electrode extending in a first direction, and the plurality of first control electrodes are arranged in the first control circuit layer in electrical isolation from each other; and the second control electrode is a second strip electrode extending in a second direction perpendicular to the first direction, and the plurality of second control electrodes are arranged in the second control circuit layer in electrical isolation from each other.

In some embodiments, each pixel region in the mask comprises at least a part of one first control electrode and at least a part of one second control electrode.

In some embodiments, each pixel region in the mask comprises at least a part of more than one first control electrodes and at least a part of more than one second control electrodes.

In some embodiments, a ratio of an area of a region occupied by the first control electrodes to an area of a region not occupied by the first control electrodes in the first control circuit layer is 100%~1000%; and/or a ratio of an area of a region occupied by the second control electrodes to an area of a region not occupied by the second control electrodes in the second control circuit layer is 100%~1000%.

In some embodiments, the ratio of the area of the region occupied by the first control electrodes to the area of the region not occupied by the first control electrodes in the first control circuit layer is equal to the ratio of the area of the region occupied by the second control electrodes to the area of the region not occupied by the second control electrodes in the second control circuit layer.

In some embodiments, the plurality of first control electrodes in the first control circuit layer are periodically arranged; and/or the plurality of second control electrodes in the second control circuit layer are periodically arranged.

In some embodiments, an arrangement period of the plurality of first control electrodes in the first control circuit layer is 50 nm~50 µm; and/or an arrangement period of the plurality of second control electrodes in the second control circuit layer is 50 nm~50 µm.

In some embodiments, the arrangement period of the plurality of first control electrodes in the first control circuit layer is equal to the arrangement period of the plurality of second control electrodes in the second control circuit layer.

In some embodiments, the first control electrode comprises at least one of indium tin oxide, aluminum-doped zinc oxide, conductive diamond, or conductive aluminum nitride; and/or the second control electrode comprises at least one of indium tin oxide, aluminum-doped zinc oxide, conductive diamond, or conductive aluminum nitride.

In some embodiments, a thickness of the first control electrode is 10 nm~100 nm; and/or a thickness of the second control electrode is 10 nm~100 nm.

In some embodiments, a resistivity of the first control electrode is less than that of the electrolytic reaction layer; and a resistivity of the second control electrode is less than that of the electrolytic reaction layer.

In some embodiments, a total thickness of the electrolytic reaction layer, the first control circuit layer, and the second control circuit layer is below 100 µm.

In some embodiments, the mask further comprises: a substrate, on which the first control circuit layer, the electrolytic reaction layer, and the second control circuit layer are sequentially deposited.

In some embodiments, the substrate comprises at least one of quartz or calcium fluoride.

In some embodiments, the mask comprises: a substrate configured to be transmissive to the exposure beam, wherein the exposure beam is in a first frequency band; and a photochromic layer provided on one side of the substrate and comprising a photochromic material, the photochromic layer being configured to generate a corresponding mask pattern under illumination of a modulation beam with a spatial structure, wherein the photochromic material is in a non-light-transmitting state or a light-transmitting state to the exposure beam based on whether the photochromic material is illuminated by modulation light in the modulation beam, and the modulation beam is in a second frequency band separated from the first frequency band.

In some embodiments, the substrate comprises at least one of quartz or calcium fluoride.

In some embodiments, the photochromic material is configured to be in the non-light-transmitting state to the exposure beam when illuminated by the modulation light in the modulation beam; and the photochromic material is configured to be in the light-transmitting state to the exposure beam when not illuminated by the modulation light in the modulation beam.

In some embodiments, the photochromic material is configured to be in the light-transmitting state to the exposure beam when illuminated by the modulation light in the modulation beam; and the photochromic material is configured to be in the non-light-transmitting state to the exposure beam when not illuminated by the modulation light in the modulation beam.

In some embodiments, when the photochromic material is in the light-transmitting state, transmittance to the exposure beam is 60%~99%.

In some embodiments, when the photochromic material is in the non-light-transmitting state, transmittance to the exposure beam is 5%~30%.

In some embodiments, a wavelength corresponding to the first frequency band comprises 193~405 nm.

In some embodiments, a wavelength corresponding to the first frequency band comprises at least one of 193 nm, 248 nm, 325 nm, 365 nm, or 405 nm.

In some embodiments, a wavelength corresponding to the second frequency band comprises 500~580 nm, or 580~1100 nm, or a part of 500~580 nm, or a part of 580~1100 nm.

In some embodiments, a wavelength corresponding to the second frequency band comprises 633 nm.

In some embodiments, the photochromic layer comprises a photochromic material in a shape of continuous film.

In some embodiments, a thickness of the photochromic layer is 50~200 nm or 200~5000 nm.

In some embodiments, the photochromic material comprises at least one of an organic photochromic material or an inorganic photochromic material.

In some embodiments, the photochromic material comprises 1,2-bis(5,5'-dimethyl-2,2'-bithiophen-yl) perfluorocyclopent-1-ene.

### BRIEF DESCRIPTION OF THE DRAWINGS

The accompanying drawings, which constitute a part of this specification, illustrate the embodiments of the present disclosure and serve to explain the principle of the present disclosure together with the description.

The present disclosure may be more clearly understood from the following detailed description taken in conjunction with the accompanying drawings, in which:
Fig. 1 is a structural schematic diagram of a lithographing system according to an exemplary embodiment of the present disclosure;
Fig. 2 is a structural schematic diagram of a lithographing system according to another exemplary embodiment of the present disclosure;
Fig. 3 is a structural schematic diagram of a mask according to an exemplary embodiment of the present disclosure;
Fig. 4 is a schematic diagram of a control circuit of a mask that includes a first control circuit layer and a second control circuit layer, according to an exemplary embodiment of the present disclosure;
Fig. 5 is a schematic diagram of a state of a control circuit for regulating a light-transmitting state of a pixel region of a mask;
Fig. 6 is a schematic diagram of the light-transmitting state of the pixel region of the mask in the state of the control circuit of Fig. 5;
Fig. 7 is a schematic diagram of another state of a control circuit for regulating a light-transmitting state of a pixel region of a mask;
Fig. 8 is a schematic diagram of the light-transmitting state of the pixel region of the mask in the state of the control circuit of Fig. 7;
Fig. 9 is a structural schematic diagram of a mask according to another exemplary embodiment of the present disclosure;
Fig. 10 is a schematic diagram of the mask of Fig. 9 illuminated by an exposure beam and a modulation beam;
Fig. 11 is a sectional schematic diagram of the mask of Fig. 9 illuminated by an exposure beam and a modulation beam.

### DETAILED DESCRIPTION

The present disclosure will be described below with reference to the accompanying drawings, which illustrate several embodiments of the present disclosure. However, it should be understood that the present disclosure may be presented in many different ways and is not limited to the embodiments described below; and actually, the embodiments described below are intended to make the disclosure of the present disclosure more complete, and to fully convey the scope of protection of the present disclosure to those skilled in the art. It should also be understood that the embodiments disclosed herein can be combined in various ways so that more additional embodiments are provided.

It should be understood that in all the drawings, identical reference numerals denote identical elements. In the drawings, the size of a certain feature may be deformed for clarity.

It should be understood that the terminology in the description is only used for describing a specific embodiment, and is not intended to limit the present disclosure. All terminologies (including technical and scientific terminologies) used in the description have meanings commonly understood by those skilled in the art, unless otherwise defined. A well-known function or structure may not be described in detail for brevity and/or clarity.

The terminologies "comprise", "include", and "contain" used in the description indicate the presence of the stated feature, but do not exclude the presence of one or more other features. The terminology "and/or" used in the description includes any and all combinations of one or more of associated listed items. The terminologies "between X and Y" and "between about X and Y" used in this description should be construed to include X and Y. The terminology "between about X and Y" used in this description means "between about X and about Y", and the terminology "from about X to Y" used in this description means "from about X to about Y".

In the description, when it is stated that an element is "on", "attached" to, "connected" to, "coupled" to, or "contacted" with another element, etc., the element can be directly on, attached to, connected to, coupled to, or contacted with the other element, or an intermediate element may be present. In contrast, when it is stated that an element is "directly on", "directly attached" to, "directly connected" to, "directly coupled" to, or "directly contacted" with another element, no intermediate element will be present. In the description, a feature being arranged to be "adjacent" to another feature may refer to the feature having a portion overlapped with or located above or below the adjacent feature.

In the description, spatial relation terminologies such as "above", "below", "left", "right", "front", "rear", "high", and "low" may describe the relation between one feature and another feature in the accompanying drawings. It should be understood that the spatial relation terminology encompasses different orientations of an equipment in use or operation in addition to the orientation shown in the drawings. For example, when the equipment in the drawings is inverted, the feature originally described to be "below" another feature may be described to be "above" the other feature at this time. The equipment may also be otherwise oriented (rotated 90 degrees or in another orientation), and at this time, the relative spatial relation may be interpreted accordingly.

In the process of the chip production, a desired chip structure is formed typically using the mask-based lithography technology. With the development of the lithography technology, the lithographing precision has been improved from tens of micrometers to a dozen nanometers in the past decades. In particular, in order to form the desired structure, one or more masks may, according to the layout of the chip to be processed, be fabricated in advance in the light of corresponding process steps, wherein the pattern on each mask may correspond to one layer in the layout or to a plurality of layers that can be prepared in a same step. Generally, the mask may include a substrate which can cause an exposure beam (for example, an ultraviolet beam, etc.) for changing the property of the resist (photoresist) to transmit through, and a plated film that is deposited on the substrate for preventing the above exposure beam from transmitting through.

Currently, the cost of a single sheet of mask is approximately tens of thousands of dollars, while the cost of a complete set of masks for the complete chip production process might be up to millions of dollars. Moreover, once such a mask is prepared, its structure is difficult to be altered. In a traditional application scenario, a single batch of chips including a mobile phone chip, a memory, a central processing unit (CPU), and the like, is usually in the order of millions or even hundreds of millions, so that the cost of fabricating the masks can be well shared, and thus, the mask-based lithography process can be widely applied to the fabrication and production of these chips. However, with the development of the industries such as Internet of Things, artificial intelligence, and personalized life health, production of a small-batch of chips is increasingly involved, and the number of these chips might only be tens of thousands or even less. If the mask is prepared in advance and then these chips are produced based on the mask, it is difficult to share the cost of fabricating the masks by a sufficient number of chips, resulting in a great increase in the chip cost. In addition, if these chips are directly fabricated by means of such as laser direct writing or electron beam exposure, on one hand, the yield is too low to meet the requirement of mass production, and on the other hand, it might be limited by the minimum linewidth, resulting in low performance (for example, low integration, high power consumption, etc.) and high cost of the chips, so that the market penetration of the chips is hindered.

In addition, the defect present in the mask might also result in a great increase in the cost of producing the chips. In particular, if a minor defect is present in the mask, time needs to be spent on detection and repair of the defect; and if a major defect is present in the mask, the entire mask might have to be discarded.

In order to solve the above problems and meet the production of small-batch chips for the needs of the future industry, the present disclosure provides a lithographing apparatus and a lithographing system. In such a lithographing apparatus and lithographing system, without changing the basic lithography technical route, a programmable and rewritable digital lithographing mask for reuse is employed, which can generate one or more corresponding mask patterns for lithographing exposure in real time according to the chip layout, so that the time required for fabrication and detection of the mask corresponding to the chip is greatly reduced, the cost of the chip fabrication and defect monitoring and repair of the mask in use is remarkably reduced, and the obstacle to the development of small-batch chips toward high integration is cleared.

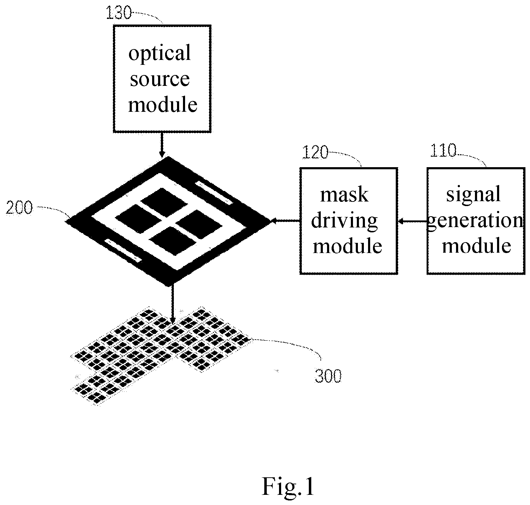

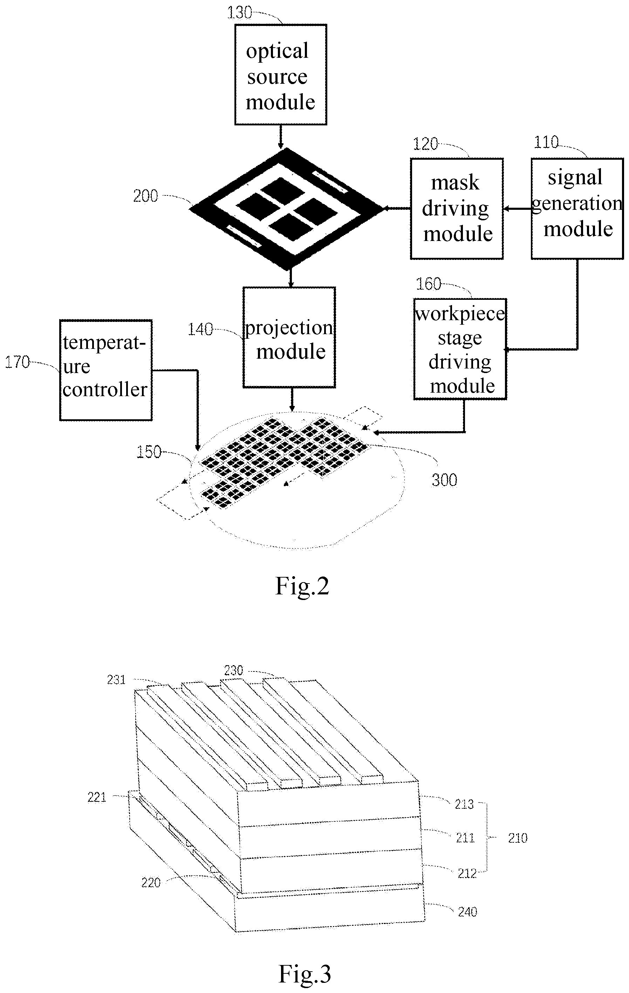

In an exemplary embodiment of the present disclosure, as shown in Figs. 1 and 2, the lithographing system may include the lithographing apparatus and a mask 200. The lithographing apparatus may include a signal generation module 110 and a mask driving module 120; and the mask 200 may include a plurality of pixel regions, and light-transmitting states for an exposure beam of at least a part of the plurality of pixel regions are configured to be changeable, to form a changeable mask pattern. The lithographing apparatus may be used for controlling a change in the mask pattern in the mask 200 to realize the lithographing system including the programmable and rewritable mask 200. In some embodiments, the mask 200 may be included in the lithographing apparatus, i.e. as a part of the lithographing apparatus. In other embodiments, the mask 200 may be provided independent of the lithographing apparatus, wherein in the lithographing process, the mask 200 is placed at an appropriate position in the lithographing apparatus to achieve exposure.

As shown in Figs. 1 and 2, the signal generation module 110 may be configured to generate one or more mask patterns according to the layout. In particular, the signal generation module 110 may analyze the layout of the chip to be processed according to the process steps, and decompose the layout into one or more mask patterns, wherein each mask pattern may correspond to one layer in the layout or to a plurality of layers in the layout that can be prepared in one same process step.

Further, the signal generation module 110 may form one or more sets of mask driving signals corresponding to each mask pattern respectively according to the one or more mask patterns obtained from the decomposition of the layout. The mask driving signal may have respective different forms according to different rewriting principles of the rewritable mask 200.

In some embodiments, the mask driving signal may be configured to control the electrolytic reaction in the pixel region to change the light-transmitting state of the pixel region. The mask driving signal may include a first driving signal and a second driving signal configured to be respectively applied to a first control electrode and a second control electrode located on two sides of the pixel region, and a voltage change on the electrolytic reaction layer between the first control electrode and the second control electrode may be used for changing the light-transmitting state of the corresponding pixel region, as will be elaborated hereinafter.

In other embodiments, the mask driving signal may be configured to drive a spatial optical modulator to generate a modulation beam, wherein the modulation beam may have a spatial structure corresponding to the mask pattern and be configured to illuminate the photochromic material in the mask to generate the mask pattern in the mask, as will be elaborated hereinafter.

In addition, the mask driving signal may further comprise an erasing signal configured to erase the mask pattern on the mask. In some embodiments, the erasing signal may be presented as a level in the mask driving signal that corresponds to an erasing state. For example, as will be elaborated hereinafter, the erasing signal may be an electric signal with opposite polarity to the electric signal for forming the non-light-transmitting pixel region in the mask, or a signal that causes the modulation beam to be turned off or deflects the modulation beam so that it cannot illuminate onto the mask, or the like.

As shown in Figs. 1 and 2, the mask driving module 120 may be communicatively connected with the signal generation module 110, and the mask driving module 120 may be configured to control the light-transmitting state of each pixel region on the mask 200 according to the one or more sets of mask driving signals respectively, to form a respective mask pattern on the mask 200. In the case where the mask 200 includes control electrodes, the mask driving module 120 may be directly electrically connected with the control electrodes in the mask 200 to transmit the respective mask driving signals to the control electrodes of the mask 200. Alternatively, when the mask 200 is illuminated, for example, by using the modulation beam with the spatial structure, to generate the corresponding mask pattern, the mask driving module 120 may be electrically connected with a device such as a spatial optical modulator to generate the desired modulation beam. Furthermore, if necessary, the mask driving module 120 may further be configured to erase the mask pattern on the mask, for example, erasing the mask pattern under the control of the erasing signal generated by the signal generation module 110.

In the mask 200, the light-transmitting state of each pixel region can be controlled by the electric signal. In some embodiments, as shown in Fig. 3, the mask may include an electrolytic reaction layer 210, a first control circuit layer 220, and a second control circuit layer 230.

In a specific example, the electrolytic reaction layer 210 may include a metal element, which may be configured to be in a deposited-metal state or in a dissolved-ion state. In general, when a thickness of the deposited metal reaches tens of nanometers or more, for example, 20~100 nm or 50~100 nm, it is sufficient to block the exposure beam for changing resist, in other words, a corresponding region in the mask where the metal is deposited will be in the non-light-transmitting state. In addition, when the metal element in the electrolytic reaction layer 210 is in the dissolved-ion state, the amount of the metal deposited in the corresponding region of the mask becomes less or even none, and thus the region may be in the light-transmitting state to make the exposure beam transmit through; the transmitted-through exposure beam may expose the resist in the corresponding region of the chip to help form the desired chip structure.

As shown in Fig. 3, the electrolytic reaction layer 210 may include an electrolyte layer 211, a first electrolytic material layer 212, and a second electrolytic material layer 213. When the metal element is in the dissolved-ion state, it can move in the electrolyte layer 211. By applying an electric field, the metal ions may be made to move in a desired direction in the electrolyte layer 211 and then be deposited onto the corresponding first or second electrolytic material layer 212 or 213 to form the non-light-transmitting region in the mask. In addition, by applying a reverse electric field, the metal deposited on the first or second electrolytic material layer 212 or 213 may be made to be dissolved into metal ions in the electrolyte layer 211 to form the light-transmitting region in the mask.

In some embodiments, the electrolytic reaction layer 210 may be based on a bimetal system with good stability, so that the mask may undergo a plurality of state changes without being damaged. For example, in the mask with the bimetal system-based electrolytic reaction layer, it can still have a transmittance contrast (transmittance in the light-transmitting state/transmittance in the non-light-transmitting state) exceeding 6 after reversible electroplating 5000 times.

For example, the electrolytic reaction layer 210 may be based on a cuprum-plumbum (Cu-Pb) electrolytic system. In particular, the electrolyte layer 211 may include a Cu-Pb electrolyte, for example, plumbum perchlorate (Pb(ClO4)2), cupric chloride (CuCl2), cuprum perchlorate (Cu(ClO4)2), and lithium perchlorate (LiClO4).

Alternatively, the electrolytic reaction layer 210 may be based on a cuprum-argentum (Cu-Ag) electrolytic system. In particular, the electrolyte layer 211 may include a Cu-Ag electrolyte, for example, cuprum perchlorate (Cu(ClO4)2), argentum perchlorate (AgClO4), and lithium chloride (LiCl).

However, it can be understood that in other embodiments, the electrolytic reaction layer 210 may also be based on deposition and dissolution of other metals, which is not limited herein.

In another specific example of the present disclosure, the electrolytic reaction layer 210 may include an electrochromic material whose transmittance may vary with a change in its ion-bonding state. When the electrochromic material is in the non-light-transmitting state, it can block the exposure beam for changing resist; while when the electrochromic material is in the light-transmitting state, it can make the exposure beam for changing the resist transmit through; the transmitted-through exposure beam may expose the resist in the corresponding region of the chip to help form a desired chip structure. The electrochromic material may be bonded with cations or anions, and exhibit non-light-transmitting in the ion-bonding state while exhibit light-transmitting in the ion-debonding state, or exhibit light-transmitting in the ion-bonding state while exhibit non-light-transmitting in the ion-debonding state, which is not limited herein. Hereinafter, the state change in the mask will be elaborated in detail by taking an example that the electrochromic material is bonded with hydrogen ions and/or lithium ions, but it can be understood that the regulation of the light-transmitting state in the mask can be also achieved by employing other electrochromic materials and ionic systems.

As shown in Fig. 3, the electrolytic reaction layer 210 may include an electrolyte layer 211, a first electrolytic material layer 212, and a second electrolytic material layer 213. In the electrolyte layer 211, at least one of lithium ions or hydrogen ions can be dissolvable, for example. By applying an electric field, the lithium ions and/or hydrogen ions may be made to move in a desired direction in the electrolyte layer 211 and then be bonded with the electrochromic material in the first electrolytic material layer 212 or in the second electrolytic material layer 213, so that the electrochromic material is in the non-light-transmitting state, and a non-light-transmitting region in the mask is formed accordingly. In addition, by applying a reverse electric field, the lithium ions and/or hydrogen ions bonded with the first electrolytic material layer 212 or the second electrolytic material layer 213 may be made to be extracted out and be detached from the first electrolytic material layer 212 or the second electrolytic material layer 213, so that the electrochromic material is in the light-transmitting state, and a light-transmitting region in the mask is formed accordingly.

As shown in Fig. 3, the first electrolytic material layer 212 may be provided between the first control circuit layer 220 and the electrolyte layer 211, and the second electrolytic material layer 213 may be provided between the electrolyte layer 211 and the second control circuit layer 230. Under the joint action of the first and second control circuit layer 220 and 230, the electric field applied to individual pixel region in the electrolytic reaction layer 110 can be controlled, thereby changing the light-transmitting state of the corresponding pixel region, as will be described in detail later.

In some embodiments of the present disclosure, the electrolyte layer 211 in the mask may be in a solid or liquid state, in other words, the electrolyte layer 211 may include solid electrolyte or liquid electrolyte. In the case where the electrolyte layer 211 is the solid electrolyte, after the electric field applied to the mask is removed, the movement of the metal element or ions therein can be still well restricted, and thus the light-transmitting region and the non-light-transmitting region of the mask can be well maintained. While in the case where the electrolyte layer 211 is the liquid electrolyte, after the electric field applied to the mask is removed, the light-transmitting region and the non-light-transmitting region of the mask may change slowly, and their stability becomes poor accordingly (but it can be appreciated that, even if the stability is poor, it can generally meet the lithograph requirement). At the same time, however, in the case where the electrolyte layer 211 is the liquid electrolyte, in the process of generating the corresponding light-transmitting and non-light-transmitting regions on the mask, the metal element may move faster in the liquid electrolyte, and thus be deposited faster on the first electrolytic material layer 212 or the second electrolytic material layer 213, or dissolved from the first electrolytic material layer 212 or the second electrolytic material layer 213, or in the process of generating the corresponding light-transmitting and non-light-transmitting regions on the mask, the ions may move faster in the liquid electrolyte, and thus be bonded faster with the electrochromic material in the first electrolytic material layer 212 or the second electrolytic material layers 213, or be detached from the electrochromic material in the first electrolytic material layer 212 or the second electrolytic material layer 213, so as to achieve faster switching between the light-transmitting state and the non-light-transmitting state. In practical applications, the corresponding electrolyte layer can be selected according to requirements.

In some embodiments, the first electrolytic material layer 212 and the second electrolytic material layer 213 in the electrolytic reaction layer 210 may be formed using a material that is transmissive to the exposure beam and has certain conductivity.

In the case where the editable mask pattern is realized based on reversible metal film electroplating, one of the first and second electrolytic material layers 212, 213 may include conductive diamond, indium tin oxide (ITO), or ITO modified by platinum (Pt) nanoparticles. The conductive diamond is transparent to the ultraviolet light within the waveband of 193~405 nm, and thus it can be used in the mask based on exposure by the ultraviolet light of the above waveband; while the ITO is transparent to the ultraviolet light within a range of 360~405 nm and has a certain blocking effect on the ultraviolet light of a smaller wavelength, and thus it can be used in the mask based on exposure by the ultraviolet light of the waveband of 360~405 nm. Further, by modifying ITO using the Pt nanoparticles, it is possible to cause the metal to be deposited more uniformly on the corresponding electrolytic material layer, and then cause each non-light-transmitting region formed in the mask to block the light more uniformly. In addition, the other of the first and second electrolytic material layers 212, 213 may include platinum (Pt) to form the counter electrode. When the metal has a sufficiently low thickness (for example, 10 nm or so), it can have a good transmittance to avoid blocking the exposure beam.

In the case where the editable mask pattern is realized based on insertion/extraction of ions in the electrochromic material, at least one of the first electrolytic material layer 212 or the second electrolytic material layer 213 is the electrochromic material. In a specific example, the electrochromic material may include magnesium-nickel alloy (Mg-Ni), magnesium-yttrium alloy (Mg-Y), metal oxide such as niobium oxide (NbOₓ) glass or niobium oxide (NbOₓ) glass modified by indium tin oxide (ITO) nanoparticles. The other of the first electrolytic material layer 212 and the second electrolytic material layer 213 may include transition metal oxide, such as wolfram oxide (WO3). Reversible changes in the light-transmitting state to the ultraviolet light within the waveband of 365~405 nm can be realized using reversible hydrogenation for Mg-Ni or Mg-Y, while reversible changes in the light-transmitting state to the ultraviolet light around 405 nm can be realized using an NbOₓ film material modified by ITO nanoparticles.

In some embodiments of the present disclosure, the electrolytic reaction layer 210 may be in a shape of continuous film. In particular, the electrolyte layer 211 in the electrolytic reaction layer 210 may include the electrolyte material in the shape of continuous film, the first electrolytic material layer 212 may include a first electrolyte material in a shape of continuous film, and the second electrolytic material layer 213 may include a second electrolytic material in a shape of continuous film. The electrolytic reaction layer 210 in the shape of continuous film is easy to be prepared in the mask, and there is no problem of alignment with other components (for example, the first control electrode 221 in the first control circuit layer 220 and the second control electrode 231 in the second control circuit layer 230) in the mask in the process of manufacturing the mask, thus the cost of the mask can be effectively reduced. In addition, by using the material with high resistivity, electric field interference between adjacent regions in the electrolytic reaction layer 210 may be avoided, thereby independently controlling the light-transmitting state of each region.

However, in some other embodiments, in order to further enhance isolation between individual pixel regions in the mask, to avoid electric field interference between adjacent pixel regions, so that the metal element in each pixel region is only or substantially independently controlled by the electric field applied to the pixel region; one or more layers in the electrolytic reaction layer 210 may be provided as a plurality of blocks arranged in an array (for example, in a rectangular array), and each pixel region in the mask may include one or more adjacent blocks (for example, each pixel region includes one block, or each pixel region includes 2×2, four in total, blocks adjacent to each other, etc.) . In particular, the electrolyte layer 211 may include a plurality of electrolyte material blocks arranged in an array, and each pixel region in the mask may include one or more electrolyte material blocks; and/or the first electrolytic material layer 212 may include a plurality of first electrolytic material blocks arranged in an array, and each pixel region in the mask may include one or more first electrolytic material blocks; and/or the second electrolytic material layer 213 may include a plurality of second electrolytic material blocks arranged in an array, and each pixel region in the mask may include one or more second electrolytic material blocks. However, in this case, in the process of preparing the mask, the problem of alignment among the layers inside the electrolytic reaction layer 210 or the electrolytic reaction layer 210 and other components (for example, the first control electrode 221 in the first control circuit layer 220 and the second control electrode 231 in the second control circuit layer 230) in the mask generally needs to be considered, and thus it might cause an increase in the cost of the mask.

As shown in Figs. 3, 4, 5, and 7, in order to control the light-transmitting state of each pixel region in the mask, a control circuit that is similar to a charge coupled device (CCD) driving circuit in a digital camera or a display driving circuit in a display may be adopted. In particular, the first control circuit layer 220 may be provided on the first side of the electrolytic reaction layer 210, and the first control circuit layer 220 may include a plurality of first control electrodes 221. Similarly, the second control circuit layer 230 may be provided on the second side of the electrolytic reaction layer 210 that is opposite to the first side, and the second control circuit layer 230 may include a plurality of second control electrodes 231. One of the first control electrode 221 and the second control electrode 231 is similar to a scan line in the CCD driving circuit or in the display driving circuit, while the other one of the first control electrode 221 and the second control electrode 231 is similar to a data line in the CCD driving circuit or in the display driving circuit. At least a part of each first control electrode 221 may be overlapped with at least a part of one corresponding second control electrode 231 in a thickness direction of the mask, so that the intersection region of the first control electrode 221 and the second control electrode 231 of the mask is controlled by the electric field between the first control electrode 221 and the second control electrode 231, that is, the metal element or the ions in the electrolyte layer 211 at the intersection may move under the action of the above electric field, wherein the metal may be deposited on the first electrolytic material layer 212 or the second electrolytic material layer 213, or be detached from the first electrolytic material layer 211 or the second electrolytic material layer 213 and be dissolved into the electrolyte layer 211, or wherein the ions may be bonded with the electrochromic material in the first electrolytic material layer 112 or in the second electrolytic material layer 113, or be detached from the electrochromic material in the first electrolytic material layer 111 or in the second electrolytic material layer 113, thereby changing the light-transmitting state at the intersection. In other words, the light-transmitting state of the pixel region in the mask may be configured to be decided by the control voltage between at least a part of the first control electrode 221 and at least a part of the second control electrode 231 contained in the pixel region, or by a loading history of the control voltage between at least a part of the first control electrode 221 and at least a part of the second control electrode 231 contained in the pixel region, the part of the first control electrode 221 and the part of the second control electrode 231 being overlapped in the thickness direction of the mask, the control voltage controlling the light-transmitting state of the pixel region by controlling the deposition amount of the metal in the electrolytic reaction layer 210 or by controlling the ion-bonding state of the electrochromic material in the electrolytic reaction layer 210.

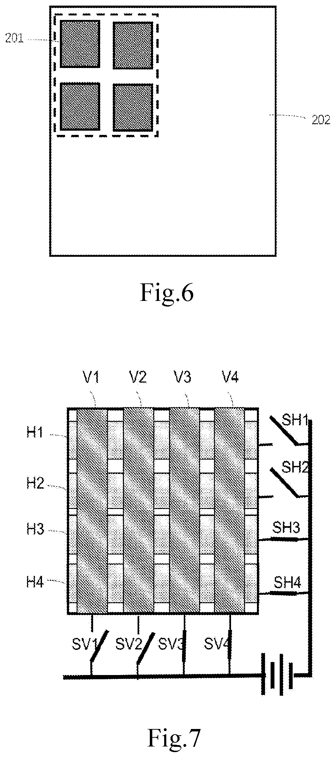

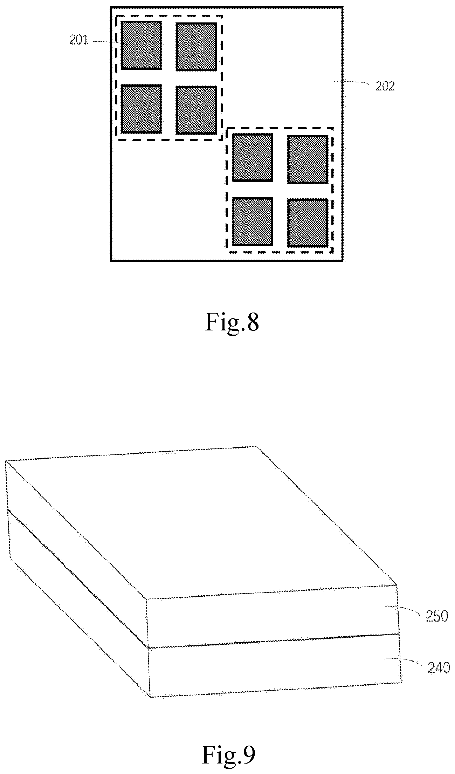

In some embodiments, the region at each intersection may be formed as one pixel region (for example, each minimum shadow region shown in Figs. 6 and 8 may be regarded as one pixel region in the non-light-transmitting state). In other words, each pixel region in the mask may include at least a part of one first control electrode and at least a part of one second control electrode (for example, including a part of the first control electrode and a part of the second control electrode that are overlapped with each other). Alternatively, in some other embodiments, one pixel region may be jointly formed by the regions at a plurality of intersections adjacent to each other (for example, as shown in Figs. 6 and 8, one region including four intersection regions and represented by a dashed box may be regarded as one pixel region in the non-light-transmitting state). In other words, each pixel region in the mask may include at least a part of more than one first control electrodes and at least a part of more than one second control electrodes (for example, including a part of each first control electrode of two first control electrodes and a part of each second control electrode of two second control electrodes).

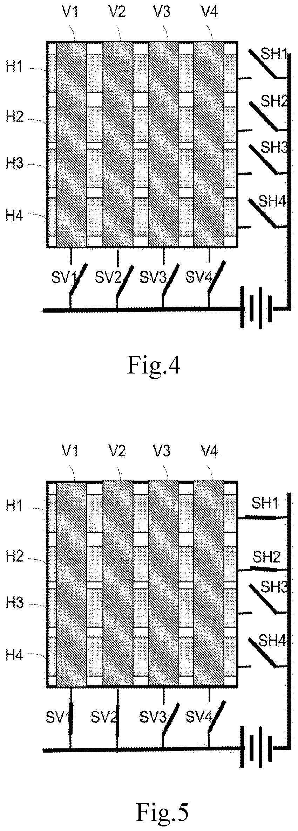

In some embodiments, as shown in Figs. 4, 5 and 7, each of the plurality of first control electrodes (H1, H2, H3, and H4) may be respectively connected to a first pole (for example, a cathode shown in the figures) of a control power supply via a respective first switching device (SH1, SH2, SH3, and SH4), while each of the plurality of second control electrodes (V1, V2, V3, and V4) may be respectively connected to a second pole (for example, an anode shown in the figure) of the control power supply via a respective second switching device (SV1, SV2, SV3, and SV4) . As such, the voltage applied to each control electrode can be controlled by controlling an on or off state of each switching device, and then the light-transmitting state of a respective pixel region in the mask is controlled. Further, as described above, in the electrolytic reaction layer 210, even if the applied external electric field is removed, the dissolved or deposited state of the metal element, or the bonding or debonding state of the ions with the electrochromic material in a respective region can still be maintained, and thus the light-transmitting state of each pixel region in the mask can be controlled by controlling one or more first switching devices and one or more second switching devices stepwise. The switching device may include a device such as a field effect transistor, which is not limited herein. In some embodiments, the switching devices may be provided jointly in the control circuit layer of the mask. Alternatively, in some other embodiments, the switching device may be provided outside the mask to avoid interference to the light-transmitting state of each pixel region in the mask. As described below, in some embodiments, respective control signals may be applied directly to the control electrodes, thereby omitting the switching devices.

In a specific example, as shown in Figs. 5 to 8, if it is desired to form a non-light-transmitting region shown in Fig. 8 (the shaded part shown in the figure) on the mask, this can be done in two steps.

First, as shown in Fig. 5, by switching on the switching devices SH1, SH2, SV1, and SV2 and switching off the switching devices SH3, SH4, SV3, and SV4, an electric field directing from the second control electrode V1 to the first control electrode H1 is applied onto the intersection region of the first control electrode H1 and the second control electrode V1, and accordingly, metal ions in the electrolyte layer 211 of the region will move toward the first control electrode H1 and then be deposited on the first electrolytic material layer 112 of the region, or the hydrogen ions and/or lithium ions in the electrolyte layer 211 of the region will move toward the first control electrode H1 and then be bonded with the electrochromic material in the first electrolytic material layer 212 of the region. As such, the intersection region of the first control electrode H1 and the second control electrode V1 of the mask will be in the non-light-transmitting state. Similarly, the intersection region of the first control electrode H1 and the second control electrode V2, the intersection region of the first control electrode H2 and the second control electrode V1, and an intersection region of the first control electrode H2 and the second control electrode V2 will all be presented in the non-light-transmitting states, like the non-light-transmitting region 201 shown in Fig. 6. In other areas of the mask, however, since the electric field as described above is not formed, the metal element in the electrolyte layer 211 may be present in form of ions, or the hydrogen ions and/or lithium ions in the electrolyte layer 211 are not bonded with the electrochromic material, so that the electrochromic material is still maintained in the light-transmitting state, thereby the corresponding regions of the mask are in the light-transmitting state, like the light-transmitting region 202 shown in Fig. 6. In conclusion, the mask with the pattern as shown in Fig. 6 can be formed.

Then, as shown in Fig. 7, by switching on the switching devices SH3, SH4, SV3, and SV4 and switching off the switching devices SH1, SH2, SV1, and SV2, an electric field directing from the second control electrode V3 to the first control electrode H3 is applied onto the intersection region of the first control electrode H3 and the second control electrode V3, and accordingly, metal ions in the electrolyte layer 211 of the region will move toward the first control electrode H3 and then be deposited on the first electrolytic material layer 212 of the region, or hydrogen ions and/or lithium ions in the electrolyte layer 211 of the region will move toward the first control electrode H3 and then be bonded with the electrochromic material in the first electrolytic material layer 212 of the region. As such, the intersection region of the first control electrode H3 and the second control electrode V3 of the mask will be in the non-light-transmitting state. Similarly, the intersection region of the first control electrode H3 and the second control electrode V4, the intersection region of the first control electrode H4 and the second control electrode V3, and the intersection region of the first control electrode H4 and the second control electrode V4 will all be presented in the non-light-transmitting states, like the non-light-transmitting region 201 shown in Fig. 8. In other areas of the mask, however, since the electric field as described above is not formed, the metal element may be maintained in its original state, or the ions may be maintained in their original forms, so that the intersection region of the first control electrode H1 and the second control electrode V1, the intersection region of the first control electrode H1 and the second control electrode V2, the intersection region of the first control electrode H2 and the second control electrode V1, and the intersection region of the first control electrode H2 and the second control electrode V2 are still maintained in the non-light-transmitting states (like the non-light-transmitting region 201 shown in Fig. 8), while the remaining regions are maintained in the light-transmitting states, like the light-transmitting region 202 shown in Fig. 8. In conclusion, the mask with the pattern as shown in Fig. 8 can be formed.

In some embodiments, in order to achieve automatic control of the pattern on the mask, the first driving signal applied onto each first control electrode and the second driving signal applied onto each second control electrode may be generated by the signal generation module 110 described above based on one or more mask patterns to be formed. The first and second driving signals may be applied onto the first and second control electrodes directly or through respective switching devices (as shown in Figs. 4, 5, and 7) . By setting level states of the first and second driving signals in each time period, the light-transmitting state of the pixel region that includes at least a part of the first control electrode and at least a part of the second control electrode that are overlapped of the mask can be changed automatically and continuously, and in some cases, the switching devices can be omitted, or changing the on or off state of individual switching device manually can be avoided.

It can be understood that in another specific example, the mask may include more or fewer first and second control electrodes. For example, it is possible to form first control electrodes with the number of 1000-100000 and the second control electrodes with the number of 1000-100000 on the mask, and then form the pixel regions in the order of 1000×1000~100000×100000, which is not limited herein. Furthermore, in some embodiments, according to different directions of the first and second poles (anode and cathode) of the control power supply, the metal might be deposited on the second electrolytic material layer 231 to form the non-light-transmitting region, or the ions might be bonded with the electrochromic material provided in the second electrolytic material layer 231 to form the non-light-transmitting region, which is not limited herein. Further, according to the desired mask pattern, on or off states of a different number of switching devices connected to different control electrodes may be separately controlled in each step of forming the mask pattern, which is not limited herein.

In addition, when it is necessary to erase or change the pattern on the mask, i.e. to change the light-transmitting states of one or more pixel regions on the mask, so that the mask can be used for preparation of another different structure, the control power supply may be reversed, i.e. the first pole and the second pole (anode and cathode) of the control power supply are exchanged, combined with on or off of respective switching devices , so that the metal deposited in the non-light-transmitting region is detached and dissolved into the electrolyte layer 211 to exist in form of ions, or the ions bonded with the electrochromic material are detached and exist in the electrolyte layer 211, and thus the regions are converted into the light-transmitting states.

In order to simplify the structure of the control circuit layer, the light-transmitting state of each pixel region in the mask is controlled using as few switching devices or control signals as possible, as shown in Figs. 3, 4, 5, and 7, the first control electrode 221 may be a first strip electrode extending in a first direction, and a plurality of first control electrodes 221 may be arranged in the first control circuit layer 220 in electrical isolation from each other, so that the voltage applied to each first control electrode 221 can be individually controlled. Similarly, the second control electrode 231 may be a second stripe electrode extending in a second direction perpendicular to the first direction, and a plurality of second control electrodes 231 may be arranged in the second control circuit layer 230 in electrical isolation from each other, so that the voltage applied to each second control electrode 231 can be individually controlled. And by providing the first and second strip electrodes, an intersection region between the first and second control electrodes 221 and 231 can be conveniently formed without performing complicated alignment in the process of preparing the mask. However, it can be understood that, in other embodiments, the control electrodes 231 may be arranged in another form, and the light-transmitting state of each intersection region may be controlled as long as an electric field applied to the overlapping part between the first and second control electrodes 221 and 231 in the thickness direction of the mask can be independently controlled, which is not limited herein. For example, when the mask has a large area, two or more first strip electrodes or second strip electrodes may be provided in a same horizontal direction or vertical direction, to avoid excessive attenuation of the applied control signal across different regions of the electrode, or the like.

In some embodiments, the ratio of the area of the region occupied by the first control electrodes 221 to the area of the region not occupied by the first control electrodes 221 in the first control circuit layer 220 may be 100%~1000%. Similarly, the ratio of the area of the region occupied by the second control electrodes 231 to the area of the region not occupied by the second control electrodes 231 in the second control circuit layer 230 may be 100%~1000%. On the one hand, the greater the ratio, the greater the area of the region occupied by the control electrodes in the corresponding control circuit layer, thus when the region is set as the non-transparent region, the better the effect of blocking the exposure beam can be, especially in the case where one pixel region is formed by the regions at a plurality of intersections, the smaller the gap between adjacent electrodes in the pixel region, the better the light blocking performance. However, due to small spacing between the control electrodes in the same control circuit layer, it might cause an increase in the difficulty in preparing the control electrode array, for example, since a proximity effect or the like causes spacing between adjacent control electrodes to be smaller than the design spacing or be even zero, it causes a short circuit between the adjacent control electrodes, or the like. On the other hand, the smaller the ratio, it helps to reduce the difficulty in the preparation of the control electrode array, but accordingly, when the spacing between the control electrodes in the same control circuit layer is large, the blocking effect on the exposure beam might be deteriorated, and especially in the case where one pixel region is formed by a plurality of intersection regions, when it is desired to regulate the pixel region to the non-light-transmitting state, the gap between the control electrodes might cause a certain degree of light leakage.

In some embodiments, the ratio of the area of the region occupied by the first control electrodes 221 to the area of the region not occupied by the first control electrodes 221 in the first control circuit layer 220 may be equal to the ratio of the area of the region occupied by the second control electrodes 231 to the area of the region not occupied by the second control electrodes 231 in the second control circuit layer 230. As such, each intersection region will have substantially the same distribution in the horizontal and vertical directions, which helps to simplify the preparation process of the mask.

In some embodiments, the plurality of first control electrodes 221 in the first control circuit layer 220 may be periodically arranged, and similarly, the plurality of second control electrodes 231 in the second control circuit layer 230 may be periodically arranged. As such, the size of each intersection region or each pixel region may be equal to each other. Further, an arrangement period of the plurality of first control electrodes 221 in the first control circuit layer 220 may be 50 nm~50 µm, and similarly, an arrangement period of the plurality of second control electrodes 231 in the second control circuit layer 230 may be 50 nm~50 µm. For example, in a specific example, the arrangement period of the plurality of first control electrodes 121 in the first control circuit layer 220 may be 5 µm, and/or the arrangement period of the plurality of second control electrodes 131 in the second control circuit layer 230 may be 5 µm. It can be appreciated that the smaller the arrangement period of the control electrodes, the higher the pattern accuracy that the mask can achieve, but accordingly, the more difficult the fabrication process of the mask might be, and the higher the fabrication cost might be.

In some embodiments, the arrangement period of the plurality of first control electrodes 221 in the first control circuit layer 220 may be equal to the arrangement period of the plurality of second control electrodes 231 in the second control circuit layer 230. As such, each intersection region will have substantially the same distribution in the horizontal and vertical directions, and it helps simplify the preparation process of the mask.

In order to avoid interference of the control circuit layer to the light-transmitting state of the mask, the first and second control electrode 221 and 231 may be formed using a material that is transparent to the exposure beam and has certain conductivity. For example, in some embodiments, the first control electrode 221 may include at least one of indium tin oxide (ITO), aluminum-doped zinc oxide, conductive diamond, or conductive aluminum nitride (AlN). Similarly, the second control electrode 231 may include at least one of indium tin oxide (ITO), aluminum-doped zinc oxide, conductive diamond, or conductive aluminum nitride (AlN). In some embodiments, the thickness of the first control electrode 220 may be 10 nm~100 nm. Similarly, the thickness of the second control electrode 230 may be 10 nm~100 nm. In addition, the resistivity of the first control electrode 221 is generally less than that of the electrolytic reaction layer 210, and the resistivity of the second control electrode 231 is also generally less than that of the electrolytic reaction layer 210, so that a desired electric field can be substantially uniformly distributed in the region corresponding to the control electrode, and interference of the electric field between adjacent intersection regions or pixel regions is avoided. In addition, a total thickness of the electrolytic reaction layer 210, the first control circuit layer 220, and the second control circuit layer 230 may be below 100 µm, to avoid too slow switching between the light-transmitting state and the non-light-transmitting state of the mask due to the excessive thickness.

Furthermore, in some embodiments of the present disclosure, as shown in Fig. 3, the mask may further include a substrate 240, wherein the first control circuit layer 220, the electrolytic reaction layer 210, and the second control circuit layer 230 may be sequentially deposited on the substrate 240. In other words, the substrate 240 may serve as a support for various layers thereon. The substrate 240 may be made of quartz glass, calcium fluoride glass, or the like which is transparent to the ultraviolet light.

In another exemplary embodiment of the present disclosure, the light-transmitting state of individual pixel region in the mask 200 may be controlled by an optical signal. As shown in Fig. 9, the mask may include a substrate 240 and a photochromic layer 250.

The substrate 240 may be configured to be transmissive to the exposure beam for lithography to avoid interference to the lithographing process. The exposure beam may be in the first frequency band, which typically corresponds to the frequency band where partial ultraviolet light is located. For example, the wavelength corresponding to the first band may include 193~405 nm. In some specific examples, the wavelength corresponding to the first band may include at least one of 193 nm, 248 nm, 325 nm, 365 nm, or 405 nm. The substrate 240 may be made of the material with a certain structural strength for supporting other layers of the mask provided thereon. As described above, the substrate 240 may be made of quartz glass, calcium fluoride glass, or the like.

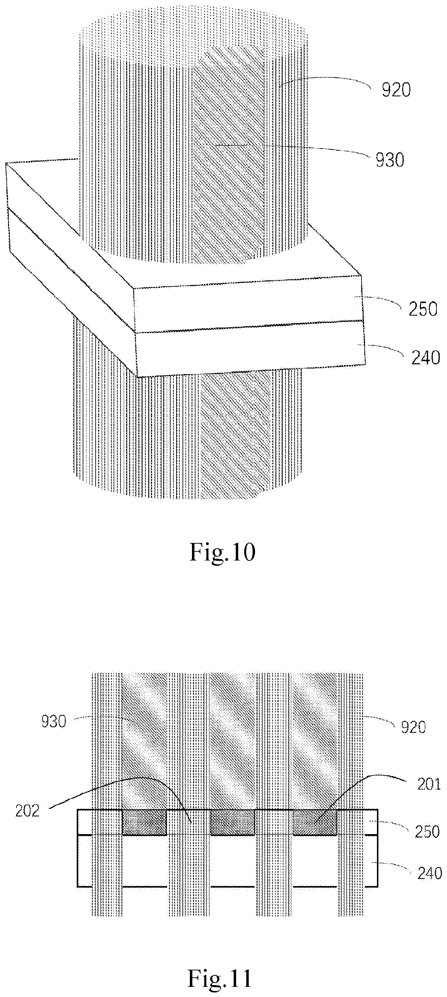

The photochromic layer 250 may be provided on one side of the substrate 240, and the photochromic layer 250 may include a photochromic material and generate a corresponding mask pattern under illumination of the modulation beam with the spatial structure. As shown in Figs. 10 and 11, the modulation beam 930 with the spatial structure specifically refers to the beam having the non-uniform intensity distribution on the section perpendicular to its travelling direction. For example, in the section perpendicular to the travelling direction of the modulation beam 930, the modulation light intensity of partial region may be zero, while another region may have a non-zero modulation light intensity. The photochromic material will be in the non-light-transmitting state or the light-transmitting state to the exposure beam based on whether it is illuminated by modulation light in the modulation beam, to form accordingly the non-light-transmitting region and the light-transmitting region in the mask, thereby generating a desired mask pattern.

In a specific example, when the photochromic material is opposite to the region on the section of the modulation beam 930 that has the non-zero modulation light intensity, i.e., the photochromic material is illuminated by the modulation light in the modulation beam 930, this part of photochromic material will absorb the modulation light and be in the non-light-transmitting state to the exposure beam (for example, the organic photochromic material absorbs the modulation light as the deexcitation light and generates a high absorption rate to the ultraviolet light as the exposure beam, resulting in that this part of organic photochromic material is in the non-light-transmitting state to the exposure beam), corresponding to the non-transmissive region 201 to the exposure beam 920 of the photochromic material shown in Fig. 11; and when the photochromic material is opposite to the region on the section of the modulation beam 930 that has the modulation light intensity of zero, i.e., the photochromic material is not illuminated by the modulation light in the modulation beam 930, this part of photochromic material will be in the light-transmitting state to the exposure beam, corresponding to the light-transmitting region 202 to the exposure beam 920 of the photochromic material shown in Fig. 11. Therefore, by controlling the intensity spatial distribution of the modulation beam, or by controlling the spatial structure of the modulation beam, the light-transmitting region 202 and the non-light-transmitting region 201 to the exposure beam 920 can be formed in the photochromic layer 250, and the combination of these regions can form the desired mask pattern in the mask.

Of course, it can be understood that, in some other specific examples, when the photochromic material is opposite to the region on the section of the modulation beam that has the non-zero modulation light intensity, i.e. when the photochromic material is illuminated by the modulation light in the modulation beam, this part of photochromic material may also be in the light-transmitting state to the exposure beam; and when the photochromic material is opposite to the region on the section of the modulation beam that has the modulation optical intensity of zero, i.e., the photochromic material is not illuminated by the modulation light in the modulation beam, this part of photochromic material can be in the non-light-transmitting state to the exposure beam.

Furthermore, in general, the non-light-transmitting state of the photochromic material may be maintained only when the modulation light illuminates on the photochromic material, and once the modulation light is removed, the photochromic material will recover to its default state, the modulation light illuminating on the mask may be removed by turning off or deflecting the modulation beam. Accordingly, when lithography is performed using a mask including such photochromic material, it is necessary to keep the modulation beam illuminating on the mask while exposing a sample using the exposure beam, to maintain the light-transmitting and non-light-transmitting regions in the mask unchanged, or keep the mask pattern unchanged until the lithography is completed. Because of the above requirements, it is necessary to avoid the interference of the modulation beam 930 to the exposure process, i.e., the modulation beam 930 cannot cause change in the property of the resist (for example, photoresist), which requires that the modulation beam 930 is in the second frequency band separated from the first frequency band for the exposure beam 920. Here, the separated first and second frequency bands refer to that any frequency in the first frequency band is different from that in the second frequency band. In some embodiments, the wavelength corresponding to the second frequency band may include 500~580 nm, or 580~1100 nm, or a part of 500~580 nm, or a part of 580~1100 nm. In a specific example, a wavelength corresponding to the second frequency band may be 633 nm.

In order to ensure that the photochromic material in the mask can, when in the light-transmitting state, cause enough exposure beam to transmit through for exposing the sample, and when in the non-light-transmitting state, be sufficient to block the exposure beam to avoid exposing the sample, transmittance of the photochromic material in the light-transmitting and non-light-transmitting states should meet a certain requirement. In a specific example, when the photochromic material is in the light-transmitting state, its transmittance to the exposure beam can be 60%~99%; and when the photochromic material is in the non-light-transmitting state, its transmittance to the exposure beam can be 5% to 30%.

In some embodiments, the photochromic material can include at least one of an organic photochromic material or an inorganic photochromic material. A common organic photochromic material may include tetracene solution, benzalphenylhydrazines solution, osazones solution, or the like in a liquid state, and 2,3,4,4-tetrachloronaphthalen-1-(4H)-one, spironaphthoxazines type organic material, diarylethene type material, azobenzene derivative, 1,2-bis(5,5'-dimethyl-2,2'-bithiophen-yl) perfluorocyclopent-1-ene, or the like in a solid state, while the inorganic photochromic material may include a various of transition metal oxides and composites thereof, such as wolfram oxide (WOₓ), molybdenum trioxide (MoO₃), vanadium pentoxide (V₂O₅), and titanium dioxide (TiO₂).

However, it is considered that in current lithographic applications in general cases, the photochromic material that can be used should have at least the following properties: (1) the light-transmitting state and the non-light-transmitting state of the photochromic material can be reversibly switched under the control of the modulation beam, to realize the rewritable and reusable mask, that is, in the case of not being illuminated by the modulation light in the modulation beam, the photochromic material has a sufficiently high transmittance to the exposure beam in the first frequency band, and in the case of being illuminated by the modulation light in the modulation beam, it has a sufficiently low transmittance to the exposure beam in the first frequency band; alternatively, in the case of not being illuminated by the modulation light in the modulation beam, it has a sufficiently low transmittance to the exposure beam in the first frequency band, and in the case of being illuminated by the modulation light in the modulation beam, it has a sufficiently high transmittance to the exposure beam in the first frequency band; and (2) the second frequency band where the modulation beam for reversibly switching the light-transmitting state and the non-light-transmitting state of the photochromic material is located is separated from the first frequency band where the exposure beam (ultraviolet light) is located, to avoid interference to the lithographing process. In view of the above considerations, in the existing process of lithographing using the ultraviolet light as the exposure beam, 1,2-bis(5,5'-dimethyl-2,2'-bithiophen-yl) perfluorocyclopent-1-ene may be used as the photochromic material in the mask. However, it can be understood that when the exposure beam or modulation beam in another frequency band is used, another photochromic material corresponding to the corresponding frequency band may be selected, which is not limited herein. Further, a photochromic material with good heat dissipation and low required modulation beam intensity can be selected to reduce a great increase in the mask temperature due to the illumination of the modulation beam, thereby improving reliability of the lithography.

In general, the photochromic layer 250 may include the photochromic material in a shape of continuous film, to facilitate the preparation of the mask by means of deposition such as lamination, spin coating, and spraying. In order to enable the photochromic material to effectively block the exposure beam when in the non-light-transmitting state, the thickness of the photochromic layer 250 may be 50~200 nm or 200∼5000 nm. In some other cases, a patterned photochromic layer may be formed as needed, and the above patterned photochromic layer may be formed by means of laser direct writing, electron beam direct writing, and lithographing based on another mask, or the like. Alternatively, in some other cases, the photochromic material in a liquid state may be used as needed, and at this time, a blocking layer may be further provided above the photochromic layer 250, so that the liquid photochromic material is limited between the substrate 240 and the blocking layer, to maintain the stable property of the structure of the mask, thereby ensuring the exposure effect.

In some embodiments, as shown in Figs. 1 and 2, the lithographing apparatus may further include an optical source module 130, to generate at least one of the exposure beam or the modulation beam with the spatial structure.

Generally, the optical source module 130 in the lithographing apparatus can include a second optical generator, which may be configured to generate the exposure beam in the first frequency band. In the lithographing process, in order to increase lithographing precision and to improve the accuracy of the lithographing pattern, the exposure beam generated by the second optical generator may be a near-field beam relative to the mask, i.e. proximity exposure is employed. In this case, the mask 200 is placed at an appropriate position between the optical source module 130 and the workpiece 300 to be lithographed, so as to form a pattern closest to the pattern to be exposed on the workpiece 300, through the exposure beam illuminating on the workpiece 300 via the mask 200.

Furthermore, in the case where a rewritable mask pattern in the mask 200 is formed using the modulation beam, the optical source module 130 may further include a first optical generator and a spatial optical modulator, wherein the first optical generator may be configured to generate an initial beam in the second frequency band, the initial beam having a uniform light intensity distribution on the section perpendicular to its travelling direction; and the spatial optical modulator may be configured to convert the initial beam into the modulation beam with the spatial structure corresponding to the desired mask pattern under the action of the mask driving signal generated by the signal generation module 110. In this case, the optical source module 130 may be communicatively connected with the signal generation module 110. Furthermore, in some embodiments, the modulation beam generated by the modulation light source may be a near-field beam relative to the photochromic layer in the mask, to avoid an influence on the precision that is caused by an optical diffraction effect of a far-field beam and to improve the accuracy of the mask pattern. In a specific example, the spatial optical modulator may be an optical phase modulator.

In some embodiments, the spatial optical modulator may achieve pixels with the number of 4160x2464 and the pixel period of 3.74 µm. Using such a spatial optical modulator, a pattern with a period of 6~8 µm that is composed of minute optical spots with a size of 3~4 µm may be formed on the mask by using the modulation beam with a wavelength of 633 nm. By using such a mask and combining a fourfold (4x) reduced projection lithography technology, the minimum linewidth which can be processed is 1 µm or so, and the area for a single exposure can be 1x1 cm². In the case of projection exposure, supposing that the time required for a single exposure is 100 ms, it is calculated that the lithographing yield of such a mask can reach 600 cm²/min. For the exposure accuracy of 1 µm, the yield described above is 100 times that of laser direct writing, and thus can meet the lithographing requirement of a next generation of printed circuit boards and chip packaging, etc. In addition, in the case that the wavelength of the modulation beam is 633 nm, the minimum resolution of the pattern that can be generated by the modulation beam is 400 nm or so, and by combining the 4x reduced projection lithography technology and using the exposure beam of 248 nm, the lithographing linewidth of about 100 nm can be achieved, which can meet the lithographing requirement of many subsequent processes of the chip. If it is desired to further improve the linewidth accuracy of the mask while improving the yield, a spatial optical modulator for 10000x10000 or more pixels can be developed. In addition, although the mask in the above embodiments might be limited by the diffraction effect of the modulation beam, the minimum linewidth on the mask is typically 400 nm or so, but by combining higher-multiple reduced projection lithography, such as a tenfold (10x) reduced projection lithography technology, and performing exposure using a deep ultraviolet (DUV) exposure beam of 193 nm, for example, the minimum linewidth for the lithographing can be further improved to below 45 nm to meet the production requirement of advanced chips.

As described above, when the mask pattern in the mask is controlled using the optical signal, it is generally necessary to keep the modulation beam illuminating on the mask at all time in the exposure process to maintain the mask pattern. Accordingly, the following steps may be followed when lithographing is performed using such a mask: making a modulation beam with a spatial structure illuminate on the mask, to generate a corresponding mask pattern on the mask; after the mask pattern is generated, making the exposure beam illuminate on a workpiece to be lithographed, via the mask, to expose the workpiece to be lithographed ; after exposing the workpiece to be lithographed, turning off the exposure beam; and after turning off the exposure beam, turning off the modulation beam. In other words, throughout the exposure process, the modulation beam should be kept illuminating on the workpiece to be lithographed at all time to maintain a stable mask pattern.

In some embodiments, as shown in Fig. 2, the lithographing apparatus may further include a projection module 140, which may be configured to project the mask pattern onto a workpiece to be lithographed for imaging according to a preset multiple, to realize lithographing with higher precision. The mask 200 may be placed at an appropriate position between the optical source module 130 and the projection module 140 to form a projection image corresponding to the layout at the workpiece to be lithographed.

In order to hold the workpiece to be lithographed, as shown in Fig. 2, the lithographing apparatus may further include a workpiece stage 150. In some embodiments, the workpiece stage 150 may move, for example, in a direction indicated by a dashed arrow in the figure, to move the carried workpiece to be lithographed to a desired position.

Further, in some embodiments, the signal generation module 110 may further be configured to generate one or more workpiece positioning driving signals respectively corresponding to each mask driving signal of the one or more sets of mask driving signals, wherein the workpiece positioning driving signal may be configured to position the workpiece 300 to be lithographed to a preset position. The workpiece positioning driving signal may be transmitted directly to the workpiece stage 150 to drive it to move to the corresponding position.

In other embodiments, in order to drive the workpiece stage 150, as shown in Fig. 2, the lithographing apparatus may further include a workpiece stage driving module 160, which may be communicatively connected with the signal generation module 110 and the workpiece stage 150, and may be configured to drive the workpiece stage to move to the corresponding preset position according to one or more workpiece positioning driving signals, respectively.

When the signal generation module 110 generates one or more sets of interrelated mask driving signals and workpiece positioning driving signals, in each exposure process, a respective set of mask driving signal and workpiece positioning driving signal can be invoked, to form a respective mask pattern on the mask 200 according to the mask driving signal therein, and to move the workpiece stage to a respective position according to the workpiece positioning driving signal therein, and after the mask pattern and the workpiece stage are in place, the lithographing exposure can be performed. After the exposure, operations such as developing, coating or etching may further be performed on the workpiece. In the process of performing lithographing exposure next time, a next set of mask driving signal and workpiece positioning driving signal may be invoked and similar operations may be performed according to the above steps, until the fabrication of the entire chip is completed.

In addition, considering that there might be a change in a temperature of the workpiece to be lithographed in the operating process of the lithographing system, especially in the case of controlling the light-transmitting state or the non-light-transmitting state of the photochromic material in the mask using the modulation beam, it is prone to cause a great increase in the temperature of the workpiece to be lithographed since the modulation beam usually has high optical power, as shown in Fig. 2, the lithographing apparatus may further include a temperature controller 170. The temperature controller 170 may include a temperature maintaining unit, which may be configured to be provided adjacent to the mask 200 to maintain the temperature of the mask 200 within a preset temperature range. The temperature controller 170 may be a liquid cooled temperature controller, a thermoelectric semiconductor temperature controller, etc., which is not limited herein. In general, the light intensity of the exposure beam required in the exposure process is typically 10~10000 mW/cm², while the light intensity of the modulation beam for changing the light-transmitting state of the photochromic material is typically required to be within a range of 10~10000W/cm². For example, in the lithographing process, the light intensity of the modulation beam with the wavelength of 633 nm might be more than 1000 times that of the exposure beam with the wavelength of 325 nm. By maintaining the mask 200 within the preset temperature range using the temperature controller 170, the mask 200 can be prevented from being damaged under the action of the strong modulation beam, and it can be even realized that the photochromic material in the mask is excited using a modulation beam with higher intensity (e.g. 100 kW/cm²), to rapidly change the light-transmitting state of the photochromic material and obtain the desired transmittance as ideal as possible.

The lithographing apparatus and the lithographing system of the present disclosure can be applied to fields such as scientific research, process research and development, and industrial production. The digital lithographing mask that can be repeatedly programmed using the digital file is used, and the layout is converted into one or more sets of mask driving signals based on the design layout of the chip according to the production process of the chips of the current batch, to rewrite the mask pattern on the mask, thereby saving a large amount of time that needs to be spent on fabricating a fixed and unchanged mask in the existing chip production process, reducing the fabrication cost, reducing the problems caused by monitoring the mask defect, and achieving low-cost fabrication of the chips with small-batch, high-integration, and high-performance. In addition, by combining the projection exposure technology and LELE (Lithography Etch Lithography Etch) technology and the like, the lithographing apparatus and the lithographing system of the present disclosure can also meet the production requirements of small-batch chips of 14 nm or even more advanced process nodes.

Although exemplary embodiments of the present disclosure have been described, those skilled in the art should appreciate that numerous variations and modifications may be made to the exemplary embodiments of the present disclosure without essentially departing from the spirit and scope of the present disclosure. Therefore, all the variations and modifications are included within the scope of protection of the present disclosure that is defined in the claims. The present disclosure is defined by the appended claims, and equivalents of these claims are also included therein.

## Claims

1. A lithographing apparatus, comprising:
a signal generation module configured to generate one or more mask patterns according to a layout, and to generate a respective mask driving signal according to each of the one or more mask patterns respectively; and
a mask driving module communicatively connected with the signal generation module and configured to control a light-transmitting state of each pixel region on a mask according to one or more sets of mask driving signals respectively, so as to form a respective mask pattern on the mask.

2. The lithographing apparatus according to claim 1, wherein the mask driving signal is configured to control an electrolytic reaction in the pixel region to change the light-transmitting state of the pixel region, and the mask driving signal comprises a first driving signal and a second driving signal configured to be respectively applied to a first control electrode and a second control electrode located on two sides of the pixel region.

3. The lithographing apparatus according to claim 1, wherein the mask driving signal is configured to drive a spatial optical modulator to generate a modulation beam, wherein the modulation beam has a spatial structure corresponding to the mask pattern and is configured to illuminate a photochromic material in the mask to generate the mask pattern in the mask.

4. The lithographing apparatus according to claim 3, further comprising:
a first optical generator configured to generate an initial beam in a second frequency band, the initial beam having a uniform optical intensity distribution on a section perpendicular to its travelling direction; and
the spatial optical modulator configured to convert the initial beam into the modulation beam with the spatial structure under an action of the mask driving signal.

5. The lithographing apparatus according to claim 1, wherein the mask driving signal comprises an erasing signal configured to erase the mask pattern on the mask.

6. The lithographing apparatus according to claim 1, wherein the mask driving module is configured to erase the mask pattern on the mask.

7. The lithographing apparatus according to claim 1, further comprising:
a workpiece stage configured to hold a workpiece to be lithographed.

8. The lithographing apparatus according to claim 7, wherein the signal generation module is further configured to generate one or more workpiece positioning driving signals respectively corresponding to each of the one or more sets of mask driving signals, the workpiece positioning driving signal being configured to position the workpiece to be lithographed to a preset position.

9. The lithographing apparatus according to claim 8, further comprising:
a workpiece stage driving module communicatively connected with the signal generation module and the workpiece stage, and configured to drive the workpiece stage to move to the corresponding preset position according to the one or more workpiece positioning driving signals respectively.

10. The lithographing apparatus according to claim 1, further comprising:
a second optical generator configured to generate an exposure beam in a first frequency band.

11. The lithographing apparatus according to claim 1, further comprising:
a projection module configured to project the mask pattern to a workpiece to be lithographed for imaging according to a preset multiple.

12. The lithographing apparatus according to claim 1, further comprising:
a temperature controller comprising a temperature maintaining unit configured to be provided adjacent to the mask, to maintain a temperature of the mask within a preset temperature range.

13. A lithographing system, comprising:
the lithographing apparatus according to any one of claims 1 to 12; and
a mask comprised in or provided independent of the lithographing apparatus, the mask comprising a plurality of pixel regions, wherein light-transmitting states for an exposure beam of at least a part of the plurality of pixel regions are configured to be changeable to form a changeable mask pattern.

14. The lithographing system according to claim 13, wherein the mask comprises:
an electrolytic reaction layer;
a first control circuit layer provided on a first side of the electrolytic reaction layer and comprising a plurality of first control electrodes; and
a second control circuit layer provided on a second side of the electrolytic reaction layer that is opposite to the first side and comprising a plurality of second control electrodes,
wherein the light-transmitting state for the exposure beam of the pixel region in the mask is configured to be decided by a control voltage between at least a part of the first control electrode and at least a part of the second control electrode contained in the pixel region.

15. The lithographing system according to claim 14, wherein the electrolytic reaction layer comprises metal element configured to be in a deposited-metal state or a dissolved-ion state, the control voltage controlling the light-transmitting state of the pixel region by controlling a deposition amount of metal in the electrolytic reaction layer.

16. The lithographing system according to claim 15, wherein the electrolytic reaction layer comprises:
an electrolyte layer;
a first electrolytic material layer provided between the first control circuit layer and the electrolyte layer; and
a second electrolytic material layer provided between the electrolyte layer and the second control circuit layer.

17. The lithographing system according to claim 16, wherein the electrolyte layer comprises cuprum-plumbum electrolyte.

18. The lithographing system according to claim 17, wherein the electrolyte layer comprises plumbum perchlorate, cupric chloride, cuprum perchlorate, and lithium perchlorate.

19. The lithographing system according to claim 16, wherein the electrolyte layer comprises cuprum-argentum electrolyte.

20. The lithographing system according to claim 19, wherein the electrolyte layer comprises cuprum perchlorate, silver perchlorate, and lithium chloride.

21. The lithographing system according to claim 16, wherein one of the first electrolytic material layer and the second electrolytic material layer comprises conductive diamond, indium tin oxide, or indium tin oxide modified by platinum nanoparticles.

22. The lithographing system according to claim 21, wherein another of the first electrolytic material layer and the second electrolytic material layer comprises platinum.

23. The lithographing system according to claim 14, wherein the electrolytic reaction layer comprises an electrochromic material, the control voltage controlling the light-transmitting state of the pixel region by controlling an ion-bonding state of the electrochromic material in the electrolytic reaction layer.

24. The lithographing system according to claim 23, wherein the electrolytic reaction layer comprises:
an electrolyte layer;
a first electrolytic material layer provided between the first control circuit layer and the electrolyte layer; and
a second electrolytic material layer provided between the electrolyte layer and the second control circuit layer.

25. The lithographing system according to claim 24, wherein at least one of lithium ions or hydrogen ions are dissolvable in the electrolyte layer.

26. The lithographing system according to claim 24, wherein one of the first electrolytic material layer and the second electrolytic material layer comprises the electrochromic material.

27. The lithographing system according to claim 26, wherein one of the first electrolytic material layer and the second electrolytic material layer comprises magnesium nickel alloy, magnesium yttrium alloy, niobium oxide, or niobium oxide modified by indium tin oxide nanoparticles.

28. The lithographing system according to claim 27, wherein another of the first electrolytic material layer and the second electrolytic material layer comprises transition metal oxide.

29. The lithographing system according to claim 28, wherein another of the first electrolytic material layer and the second electrolytic material layer comprises wolfram oxide.

30. The lithographing system according to claim 16 or 24, wherein the electrolyte layer comprises solid electrolyte; or
the electrolyte layer comprises liquid electrolyte.

31. The lithographing system according to claim 16 or 24, wherein the electrolyte layer comprises an electrolyte material in a shape of continuous film;
the first electrolytic material layer comprises a first electrolytic material in a shape of continuous film; and/or
the second electrolytic material layer comprises a second electrolytic material in a shape of continuous film.

32. The lithographing system according to claim 16 or 24, wherein the electrolyte layer comprises a plurality of electrolyte material blocks arranged in an array, and each pixel region in the mask comprises one or more electrolyte material blocks;
the first electrolytic material layer comprises a plurality of first electrolytic material blocks arranged in an array, and each pixel region in the mask comprises one or more first electrolytic material blocks; and/or
the second electrolytic material layer comprises a plurality of second electrolytic material blocks arranged in an array, and each pixel region in the mask comprises one or more second electrolytic material blocks.

33. The lithographing system according to claim 14, wherein each of the plurality of first control electrodes is respectively connected to a first pole of a control power supply via a respective first switching device; and
each of the plurality of second control electrodes is respectively connected to a second pole of the control power supply via a respective second switching device.

34. The lithographing system according to claim 14, wherein each first control electrode is respectively configured to receive a first driving signal, and each second control electrode is respectively configured to receive a second driving signal, to control the light-transmitting state of the pixel region containing at least a part of the first control electrode and at least a part of the second control electrode that are overlapped.

35. The lithographing system according to claim 14, wherein the first control electrode is a first strip electrode extending in a first direction, and the plurality of first control electrodes are arranged in the first control circuit layer in electrical isolation from each other; and
the second control electrode is a second strip electrode extending in a second direction perpendicular to the first direction, and the plurality of second control electrodes are arranged in the second control circuit layer in electrical isolation from each other.

36. The lithographing system according to claim 35, wherein each pixel region in the mask comprises at least a part of one first control electrode and at least a part of one second control electrode.

37. The lithographing system according to claim 35, wherein each pixel region in the mask comprises at least a part of more than one first control electrodes and at least a part of more than one second control electrodes.

38. The lithographing system according to claim 35, wherein a ratio of an area of a region occupied by the first control electrodes to an area of a region not occupied by the first control electrodes in the first control circuit layer is 100%~1000%; and/or
a ratio of an area of a region occupied by the second control electrodes to an area of a region not occupied by the second control electrodes in the second control circuit layer is 100%~1000%.

39. The lithographing system according to claim 35, wherein the ratio of the area of the region occupied by the first control electrodes to the area of the region not occupied by the first control electrodes in the first control circuit layer is equal to the ratio of the area of the region occupied by the second control electrodes to the area of the region not occupied by the second control electrodes in the second control circuit layer.

40. The lithographing system according to claim 35, wherein the plurality of first control electrodes in the first control circuit layer are periodically arranged; and/or
the plurality of second control electrodes in the second control circuit layer are periodically arranged.

41. The lithographing system according to claim 40, wherein an arrangement period of the plurality of first control electrodes in the first control circuit layer is 50 nm~50 µm; and/or
an arrangement period of the plurality of second control electrodes in the second control circuit layer is 50 nm~50 µm.

42. The lithographing system according to claim 40, wherein the arrangement period of the plurality of first control electrodes in the first control circuit layer is equal to the arrangement period of the plurality of second control electrodes in the second control circuit layer.

43. The lithographing system according to claim 14, wherein the first control electrode comprises at least one of indium tin oxide, aluminum-doped zinc oxide, conductive diamond, or conductive aluminum nitride; and/or
the second control electrode comprises at least one of indium tin oxide, aluminum-doped zinc oxide, conductive diamond, or conductive aluminum nitride.

44. The lithographing system according to claim 14, wherein a thickness of the first control electrode is 10 nm~100 nm; and/or
a thickness of the second control electrode is 10 nm~100 nm.

45. The lithographing system according to claim 14, wherein a resistivity of the first control electrode is less than that of the electrolytic reaction layer; and
a resistivity of the second control electrode is less than that of the electrolytic reaction layer.

46. The lithographing system according to claim 14, wherein a total thickness of the electrolytic reaction layer, the first control circuit layer, and the second control circuit layer is below 100 µm.

47. The lithographing system according to claim 14, wherein the mask further comprises:
a substrate, on which the first control circuit layer, the electrolytic reaction layer, and the second control circuit layer are sequentially deposited.

48. The lithographing system according to claim 47, wherein the substrate comprises at least one of quartz or calcium fluoride.

49. The lithographing system according to claim 13, wherein the mask comprises:
a substrate configured to be transmissive to the exposure beam, wherein the exposure beam is in a first frequency band; and
a photochromic layer provided on one side of the substrate and comprising a photochromic material, the photochromic layer being configured to generate a corresponding mask pattern under illumination of a modulation beam with a spatial structure, wherein the photochromic material is in a non-light-transmitting state or a light-transmitting state to the exposure beam based on whether the photochromic material is illuminated by modulation light in the modulation beam, and the modulation beam is in a second frequency band separated from the first frequency band.

50. The lithographing system according to claim 49, wherein the substrate comprises at least one of quartz or calcium fluoride.

51. The lithographing system according to claim 49, wherein the photochromic material is configured to be in the non-light-transmitting state to the exposure beam when illuminated by the modulation light in the modulation beam; and
the photochromic material is configured to be in the light-transmitting state to the exposure beam when not illuminated by the modulation light in the modulation beam.

52. The lithographing system according to claim 49, wherein the photochromic material is configured to be in the light-transmitting state to the exposure beam when illuminated by the modulation light in the modulation beam; and
the photochromic material is configured to be in the non-light-transmitting state to the exposure beam when not illuminated by the modulation light in the modulation beam.

53. The lithographing system according to claim 49, wherein when the photochromic material is in the light-transmitting state, transmittance to the exposure beam is 60%~99%.

54. The lithographing system according to claim 49, wherein when the photochromic material is in the non-light-transmitting state, transmittance to the exposure beam is 5%~30%.

55. The lithographing system according to claim 49, wherein a wavelength corresponding to the first frequency band comprises 193~405 nm.

56. The lithographing system according to claim 49, wherein a wavelength corresponding to the first frequency band comprises at least one of 193 nm, 248 nm, 325 nm, 365 nm, or 405 nm.

57. The lithographing system according to claim 49, wherein a wavelength corresponding to the second frequency band comprises 500~580 nm, or 580~1100 nm, or a part of 500~580 nm, or a part of 580~1100 nm.

58. The lithographing system according to claim 49, wherein a wavelength corresponding to the second frequency band comprises 633 nm.

59. The lithographing system according to claim 49, wherein the photochromic layer comprises a photochromic material in a shape of continuous film.

60. The lithographing system according to claim 49, wherein a thickness of the photochromic layer is 50~200 nm or 200~5000 nm.

61. The lithographing system according to claim 49, wherein the photochromic material comprises at least one of an organic photochromic material or an inorganic photochromic material.

62. The lithographing system according to claim 49, wherein the photochromic material comprises 1,2-bis(5,5'-dimethyl-2,2'-bithiophen-yl) perfluorocyclopent-1-ene.
